# EUROPÄISCHE PATENTSCHRIFT

(11) **EP 2 467 702 B1**
(45) Veröffentlichungstag und Bekanntmachung des Hinweises auf die Patenterteilung: **17.09.2014**
(21) Anmeldenummer: 10709457.5
(22) Anmeldetag: 26.02.2010
(51) Int. Cl.: G01N 21/64, G01N 21/59, B07C 5/34, B07C 5/342

(54) **VERFAHREN UND VORRICHTUNG ZUM DETEKTIEREN VON BLEIHÄLTIGEN GLASSTÜCKEN**
METHOD AND DEVICE FOR DETECTING LEAD-CONTAINING GLASS PIECES
PROCÉDÉ ET DISPOSITIF DE DÉTECTION DE MORCEAUX DE VERRE CONTENANT DU PLOMB

(30) Priorität: 19.08.2009 AT 52009 U
(43) Veröffentlichungstag der Anmeldung: 27.06.2012
(60) Teilanmeldung: 14176570.1
(73) Patentinhaber: Binder + Co. AG, 8200 Gleisdorf (AT)
(72) Erfinder: HUBER, Reinhold, A-8280 Fürstenfeld (AT); LEITNER, Karl, A-8184 Anger (AT)
(74) Vertreter: KLIMENT & HENHAPEL
(86) Internationale Anmeldenummer: PCT/EP2010/052457
(87) Internationale Veröffentlichungsnummer: WO 2011/020628

(56) Entgegenhaltungen:
- EP-A1- 1 752 228
- EP-A2- 0 263 015
- WO-A1-2004/063729
- DE-C1- 4 339 822
- US-B2- 7 550 746

## Beschreibung

### GEBIET DER ERFINDUNG

Die vorliegende Erfindung bezieht sich auf ein Verfahren zum Detektieren von bleihältigen Glasstücken in einem einschichtigen Materialstrom von Objekten aus vorwiegend Altglas, wobei die Objekte mit im Wesentlichen monochromatischem UV-Licht bestrahlt und das daraus resultierende Fluoreszenzlicht detektiert wird, sowie einer entsprechenden Vorrichtung.

### STAND DER TECHNIK

Altglas enthält in der Regel Normalglasscherben, kann aber auch bleihältige Glasstücke (Bleiglas) sowie weniger oder nicht transparente Störstoffe wie Keramik, Stein und/oder Porzellan enthalten.

Die Wiederverwertung von Altglas, worunter auch Bruchglas fällt, mitsamt eines organisierten Sammel- und Ausleseverfahrens wird bereits seit geraumer Zeit erfolgreich praktiziert und konnte zu einer deutlichen Senkung des Energieaufwandes bei der industriellen Glasproduktion führen. Die bekannte Schwierigkeit, dass im Zuge einer Altglassammlung seitens der Konsumenten keine exakte Materialtrennung hinsichtlich Glasfarbe und artfremden Stoffen wie Keramik, Stein, Porzellan durchgeführt wird, konnte mittlerweile durch automatisierte Materialausleseverfahren mit optoelektronisch gesteuerten Sortiervorrichtungen zuverlässig bewältigt werden. Zum Zwecke der Farbsortierung und Fremdstofferkennung werden zumeist berührungslose Messmethoden mittels Infrarot- oder RGB-Sensoren eingesetzt, welche anhand des registrierten Transmissions- oder Absorptionsgrades von auf den Altglasmaterialstrom gerichtetem Licht ein Ausscheiden der unerwünschten Fremdstoffe aus dem Altglasmaterialstrom bzw. ein Ablenken von farbigen Gläsern in dafür vorgesehene Fraktionen durch nachgeschaltete Ausblas- oder Saugdüsen einleiten. Das auszusortierende Stückgut des gemischten Altglasmaterialstromes wird etwa auf einem Sortierband oder während einer Freifallstrecke durch Strahlungsquellen bestrahlt und die durch den Altglasmaterialstrom hindurchgehende oder reflektierte Strahlung in ihrer Intensität von einer Detektiereinheit aufgenommen und mit Referenzwerten verglichen. Eine mit der Detektiereinheit in Datenverbindung stehende Auswerte- und Steuereinheit nimmt in der Folge eine Zuordnung des Stückgutes zu einer jeweiligen Fraktion vor und veranlasst ein Erfassen desselben durch Aufnehmer oder ein Ablenken in vorbestimmte Container mittels Druckluft- oder Saugdüsen.

Ein Problemkreis, der bisher beim Glas-Recycling nur von untergeordneter Bedeutung war, in letzter Zeit aber zunehmend an Brisanz gewinnt, ist jedoch die Erkennung von Sonderglas im Altglasmaterialstrom. Als Sondergläser werden eigens für spezielle Anwendungen kreierte Glassorten bezeichnet, die im Vergleich zu Normalglas (Kalknatron-Glas) stark abweichende chemische und physikalische Eigenschaften, insbesondere einen wesentlich höheren Schmelzpunkt sowie bessere thermische Eigenschaften aufweisen. Hierzu zählen etwa Glaskeramik, Quarzglas, Bleiglas sowie temperatur- und hitzeschockbeständige technische Gläser wie Borosilikatgläser.

Der primäre Herstellungsprozess von Sonderglas gleicht demjenigen bei der Normalglaserzeugung, jedoch wird der Glasschmelze je nach Anwendungsgebiet ein gewisser Anteil an speziellen Oxiden beigefügt.

Die sogenannten Bleigläser bzw. bleihaltige Glasstücke enthalten Bleioxide. Sie sind einerseits als sogenanntes Bleikristallglas zwar aufgrund ihrer starken Lichtbrechung und guten Oberflächenbearbeitbarkeit sehr beliebt, müssen aus Umwelt- und Gesundheitsgründen jedoch unbedingt in speziellen Glashütten wiederaufbereitet werden, wo sie unter kontrollierten Bedingungen wiedereingeschmolzen werden. Andererseits fallen unter Bleiglas auch Bildschirme (Kathodenstrahlröhrenbildschirme), deren Bestandteile einen unterschiedlichen Anteil an Bleioxid PbO aufweisen: das Frontglas, das den sichtbaren Teil des Bildschirms bildet, weist einen Gehalt von 0,1-4% PbO auf, bei bleiarmen bzw. bleifreien Fronten liegt der Gehalt bei < 0,1% PbO. Das Konusglas weist allerdings einen Gehalt von 10-25% PbO auf. Bruchteile von Bildschirmen gehören daher entweder zum Frontglas, zum Konusglas oder zum Übergangsbereich zwischen Front und Konus, diese Glasstücke werden als Front/Konus-Fritten bezeichnet und können einen eigene aus zu sortierende Klasse von Glasstücken darstellen.

Bekannte Verfahren zur Sortierung von Sonderglas arbeiten mit Röntgensensoren, wobei bestimmte chemische Bestandteile (z.B. Aluminiumoxid) im Sonderglas mit einer Röntgenstrahlquelle erregt werden. Als Reaktion geben die erregten Elementarteilchen bzw. Elektronen Energie in Form von Licht ab, dessen Intensität schließlich gemessen und zum Zwecke der Detektion ausgewertet wird. Der industrielle Markt begegnet den Röntgensensorverfahren jedoch mit Vorbehalt, da der Einsatz von Röntgenstrahlen aufgrund der extrem kurzwelligen Strahlung stets ein gewisses Gesundheitsrisiko für im Umkreis der Anlage involvierte Personen mit sich bringt. Darüber hinaus weisen Anlagen, welche nach diesem Verfahren arbeiten, eine relativ groß dimensionierte Bauweise auf und sind durchwegs kostspielig.

Ein weiteres bekanntes Verfahren zur Sortierung von Sonderglas arbeitet mit der Eigenschaft der Fluoreszenz von Sonderglas. Hierbei wird Glas mit UV-Licht einer bestimmten Wellenlänge bestrahlt, worauf es in einem engen, sichtbaren Spektralbereich zu fluoreszieren beginnt, da das eingestrahlte Licht von im oxidischen Glas vorhandenen Verunreinigungen teilweise absorbiert und in Fluoreszenzstrahlung konvertiert wird. Anhand der Fluoreszenzfarbe können dann Rückschlüsse auf die Art des Sonderglases gezogen werden. Das zu verwendende UV-Licht ist abhängig von der Art des auszusortierenden Sonderglases. Ein solches Verfahren ist etwa aus der WO2004/063729A1 bekannt, mit dem unter anderem Bleigläser erkannt und aussortiert werden können.

Allerdings ist es nicht möglich, mit einem solchen Verfahren nicht oder wenig transparente Störstoffe zu detektieren. Solche Störstoffe werden unter dem Begriff "KSP" (Keramik, Stein und Porzellan) zusammengefasst.

### DARSTELLUNG DER ERFINDUNG

Es ist daher eine Aufgabe der vorliegenden Erfindung, ein Verfahren und eine entsprechende Vorrichtung zur Verfügung zu stellen, mit der einerseits Bleigläser detektiert werden können, andererseits aber auch Störstoffe (Keramik, Stein und Porzellan).

Diese Aufgabe wird durch ein Verfahren zum Detektieren von bleihältigen Glasstücken in einem einschichtigen Materialstrom von Objekten aus vorwiegend Altglas, wobei die Objekte mit im Wesentlichen monochromatischen UV-Licht bestrahlt und das daraus resultierende Fluoreszenzlicht detektiert wird, gemäß Anspruch 1 gelöst, indem
- die Objekte zusätzlich mit sichtbarem oder IR-Licht außerhalb des Wellenlängenbereichs des Fluoreszenzlichts bestrahlt wird,
- das Transmissionslicht des sichtbaren oder IR-Lichts nach dem Durchgang durch das Objekt detektiert wird,
- und ein Objekt dann als bleihältig definiert wird, wenn sowohl Fluoreszenzlicht für zumindest einen vorbestimmten, der Fluoreszenz von bleihältigen Gläsern entsprechenden Wellenlängenbereich in einem vorbestimmten Intensitätsbereich vorliegt als auch Transmissionslicht in einem vorbestimmten Intensitätsbereich mit Intensitäten größer Null.

Durch die Verwendung von sichtbarem oder IR-Licht (InfrarotLicht, Wellenlänge 780nm bis 1mm) können einerseits nicht oder wenig transparente Störstoffe (KSP) sicher identifiziert werden, insbesondere dann, wenn diese Fluoreszenzlicht im selben Spektralbereich wie bleihaltige Glasstücke aussenden würden. Andererseits kann vermieden werden, dass ein Glasstück, an dem Papier anhaftet, welches oft ebenfalls ein Signal im Wellenlängenbereich des Fluoreszenzlichts von bleihaltigen Glasstücken liefert, fälschlich als Bleiglas identifiziert wird.

Nicht bleihaltiges Glas wird daher im vorbestimmten Wellenlängenbereich, der dem Fluoreszenzlicht zugeordnet ist, keine oder nur eine geringe Intensität aufweisen, das Transmissionslicht wird eine höhere Intensität aufweisen als die von nicht oder wenig transparenten Störstoffen.

Bleihaltiges Glas wird im vorbestimmten Wellenlängenbereich, der dem Fluoreszenzlicht zugeordnet ist, eine höhere Intensität aufweisen als nicht bleihaltiges Glas, das Transmissionslicht wird eine höhere Intensität aufweisen als die von nicht oder wenig transparenten Störstoffen.

Nicht oder wenig transparenten Störstoffe werden keine oder nur eine - im Vergleich zu den transparenten Gläsern mit (aber auch ohne) Bleigehalt - geringere Intensität im Transmissionslicht aufweisen.

Es hat sich durch Versuche herausgestellt, dass die Verwendung von UV-C-Licht, das den Wellenlängenbereich von 100-300nm umfasst, gut geeignet ist, um nicht nur das Vorhandensein von Bleioxiden im Glas zu detektieren, sondern auch den Gehalt von Bleioxiden im Glas. Es kann also vorgesehen werden, dass das UV-Licht eine Wellenlänge im Bereich von 100 bis 300 nm, insbesondere zwischen 250 und 275 nm, aufweist und das das Fluoreszenzlicht im Wellenlängenbereich von 380-500 nm detektiert wird.

Besonders günstige Ausführungen bestehen darin, dass das UV-Licht eine Wellenlänge von etwa 270 nm aufweist und das Fluoreszenzlicht im Wellenlängenbereich von 380-450 nm detektiert wird, oder, dass das UV-Licht eine Wellenlänge von etwa 254 nm aufweist und das Fluoreszenzlicht im Wellenlängenbereich von 420-500 nm detektiert wird. Die letzte Variante hat den Vorteil, dass handelsübliche UV-C Leuchtstoffröhren mit 254 nm Wellenlänge verwendet werden können, allerdings ist dort die Bestimmung unterschiedlicher Bleigehalte schwieriger als bei einer UV-C Lichtquelle mit 270 nm Wellenlänge.

Da die Fluoreszenz ein Oberflächeneffekt ist, erhält man bessere Ergebnisse, das heißt höhere Intensitäten des Fluoreszenzlichts, wenn das Fluoreszenzlicht im Auflicht-Verfahren gemessen wird. Das heißt, UV-Lichtquelle und Detektor für Fluoreszenzlicht befinden sich auf der gleichen Seite des Objekts. Aber auch die Messung des Fluoreszenzlichts im Gegenlichtverfahren hat Vorteile, wobei sich hier der Detektor auf der gegenüberliegenden Seite der UV-Lichtquelle befindet und das durch das Objekt durchtretende und vom Scherbenrand abgestrahlte Fluoreszenzlicht misst, das je nach Dicke und Färbung des Objekts gedämpft werden kann: denn so können sowohl der Detektor für das Fluoreszenzlicht als auch der Detektor für das Transmissionslicht auf einer Seite des Objekts angeordnet werden und diese können Licht von annähernd der selben Stelle des Objekts erhalten.

Natürlich ist auch eine Kombination von Auflicht- und Gegenlicht-Detektoren zum Detektieren des Fluoreszenzlichts möglich.

Von Vorteil ist, wenn aufgrund der Intensität des Fluoreszenzlichts im vorherbestimmten Intensitätsbereich für bleihaltige Glasstücke eine weitere Unterteilung der bleihaltigen Glasstücke bezüglich Bleigehalt vorgenommen wird. So könnten zumindest zwei Klassen von Bleigläsern herausgefiltert werden, eine mit geringerem und eine mit höherem Bleioxidgehalt. Dies ist besonders gut beim Auflicht-Verfahren möglich, weil hier die Intensitäten grundsätzlich höher und von der Dicke bzw. Farbe wenig abhängig sind.

Es könnten somit die durch verschiedene Qualitätsstandards geforderte Trennung von Bleigläsern nach unterschiedlichen Bleigehaltsklassen vorgenommen werden: Bleifreies und bleiarmes Glas (< 0,1% PbO) Bleiglas A (0,1-ca.5% PbO) Bleiglas B (> ca. 5% PbO)

Die Verwendung von sichtbarem Licht oder IR-Licht ermöglicht es auch, das mittels Detektor, meist eine CCD-Kamera, aufgenommene Bild eines Objekts mittels Bildverarbeitung zu bearbeiten und so etwa auch die Form eines Objekts zu erkennen. Damit ist es dann möglich, dass für jedes untersuchte Objekt aufgrund der Bestrahlung mit sichtbarem oder IR-Licht ein Teilbereich, etwa der Randbereich oder der Innenbereich (= Bereich innerhalb des Randbereichs), des Objekts bestimmt wird und nur die Intensität des Fluoreszenzlichts des Teilbereichs zur Definition des Bleigehalts herangezogen wird. In Versuchen hat sich nämlich gezeigt, dass die Intensität des Fluoreszenzlichts an den Bruchkanten der Glasstücke höher ist als innerhalb der Randbereiche. Somit lassen sich die Intensitäten etwa in den Randbereichen zwischen unterschiedlichen Glasstücken besser vergleichen.

Wie bei bereits bekannten Verfahren kann vorgesehen sein, dass ein als bleihaltig und/oder als Störstoff definiertes Objekt aus dem Materialstrom entfernt wird, etwa durch Ausblasdüsen mittels Druckluft.

Ein Objekt wird dann als Störstoff definiert, wenn dessen Transmissionslicht in einem Intensitätsbereich liegt, der unter dem Intensitätsbereich für bleihaltige Glasstücke liegt.

Es kann auch vorgesehen werden, dass das Licht aus der UV-Lichtquelle über zumindest einen Spiegelfilter umgelenkt und gefiltert wird.

Die Vorrichtung zur Durchführung des erfindungsgemäßen Verfahrens ist dadurch gekennzeichnet, dass diese zumindest umfasst:
- eine im Wesentlichen monochromatische UV-Lichtquelle, mit welcher ein einschichtiger Materialstrom von Objekten aus vorwiegend Altglas beleuchtet werden kann,
- ein erster Detektor zum Detektieren des durch die UV-Lichtquelle im Objekt erzeugten Fluoreszenzlichts,
- eine zweite Lichtquelle, die Licht im sichtbaren Bereich oder IR-Licht außerhalb des Wellenlängenbereichs des Fluoreszenzlichts aussenden kann,
- einen zweiten Detektor zum Detektieren des Transmissionslichts des sichtbaren oder IR-Lichts nach dem Durchgang durch das Objekt,
- eine Einrichtung zum Herstellen eines einschichtigen Materialstroms aus Altglas, mit welcher der Materialstrom an der UV-Lichtquelle und an der zweiten Lichtquelle vorbeigeführt werden kann,
- sowie eine Einrichtung zum Aussortieren von bleihältigen Glasstücken, die dann ein Objekt aussortiert, wenn sowohl Fluoreszenzlicht für zumindest einen vorbestimmten, der Fluoreszenz von bleihältigen Gläsern entsprechenden Wellenlängenbereich in einem vorbestimmten Intensitätsbereich vorliegt als auch Transmissionslicht in einem vorbestimmten Intensitätsbereich mit einer Intensität größer Null.

Wie bereits beim erfindungsgemäßen Verfahren erläutert, kann die UV-Lichtquelle UV-Licht mit einer Wellenlänge im Bereich von 100 bis 300 nm, insbesondere zwischen 250 und 275 nm, aussenden und der erste Detektor Fluoreszenzlicht nur im Wellenlängenbereich von 380-500 nm detektieren. Bevorzugte Ausführungsformen sind einerseits UV-Lichtquellen mit etwa 270 nm Wellenlänge und Detektoren für Fluoreszenzlicht im Wellenlängenbereich von 380-450 nm und andererseits UV-Lichtquellen mit etwa 254 nm Wellenlänge und Detektoren für Fluoreszenzlicht im Wellenlängenbereich von 420-500 nm.

Zur Ausführung des Gegenlichtverfahrens kann vorgesehen sein, dass sich UV-Lichtquelle und der erste Detektor auf verschiedenen Seiten des Materialstroms befinden.

Um die erfindungsgemäße Vorrichtung möglichst platzsparend auszuführen, kann vorgesehen sein, dass sich UV-Lichtquelle und zweite Lichtquelle in einem gemeinsamen Gehäuse befinden und/oder dass sich erster und zweiter Detektor in einem gemeinsamen Gehäuse befinden.

Um unerwünschte Wellenlängen, insbesondere jene des sichtbaren Lichts, aus dem Spektrum der UV-Lichtquelle eliminieren zu können, sollte das UV-Licht gefiltert werden. Hierzu kann vorgesehen sein, dass die UV-Lichtquelle so in ein Gehäuse mit zumindest einem Spiegelfilter eingebaut ist, dass das Licht aus der UV-Lichtquelle über zumindest einen Spiegelfilter umgelenkt und gefiltert wird, insbesondere durch zwei normal zueinander angeordnete Spiegelfilter um 180° umgelenkt wird.

Die Erfindung wird nun anhand schematischer Figuren näher erläutert, die ein Ausführungsbeispiel einer erfindungsgemäßen Vorrichtung darstellen. In beiden Fällen kommt das Gegenlichtverfahren zur Anwendung, das heißt, UV-Lichtquelle und Detektor für Fluoreszenzstrahlung sind auf unterschiedlichen Seiten des Altglas-Materialstroms angeordnet.

### KURZE BESCHREIBUNG DER FIGUREN

Fig. 1 zeigt eine erfindungsgemäße Vorrichtung mit Filtern für die UV-Lichtquelle,
Fig. 2 zeigt eine erfindungsgemäße Vorrichtung mit Spiegelfiltern für die UV-Lichtquelle.

### WEGE ZUR AUSFÜHRUNG DER ERFINDUNG

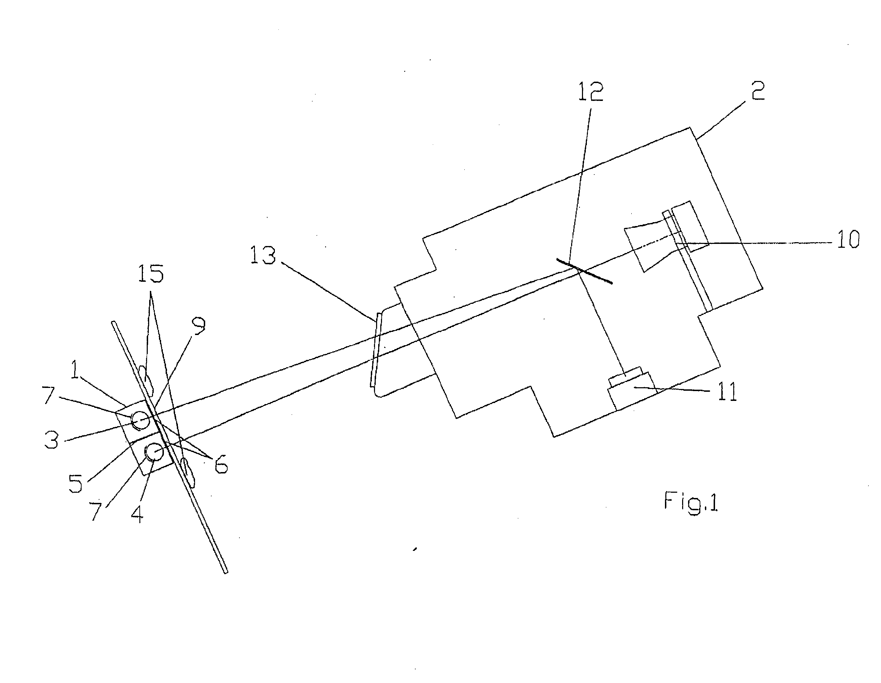

In Fig. 1 sind in einem Gehäuse 1 für Lichtquellen sowohl eine UV-Lichtquelle 3 als auch eine zweite Lichtquelle 4 eingebaut.

Die UV-Lichtquelle 3 kann UV-Licht im Bereich von 100-280 nm aussenden, insbesondere zwischen 250 und 275 nm. Sie kann in Form einer UV-C-Leuchte ausgeführt sein, die auch UV-C Leuchtstofflampe oder UV-C Leuchtstoffröhre genannt wird. Ebenso können statt einer UV-Röhre auch eine oder mehrere UV-C LEDs (LED-Line) zu Anwendung kommen.

Die zweite Lichtquelle 4 kann Licht im sichtbaren Bereich (380-780 nm Wellenlänge) und/oder im Infrarotbereich (780 nm - 1 mm Wellenlänge) aussenden und etwa - wie in diesem Beispiel - als Leuchtstofflampe (VIS-Leuchte) mit Wellenlängen im sichtbaren Bereich ausgeführt sein. Statt einer Lampe (VIS-Leuchte) können auch eine oder mehrere Farb- oder Infrarot-LEDs (LED-Line) verwendet werden.

LEDs haben gegenüber Röhrenleuchten mehrere Vorteile:
- bessere Regelbarkeit der Intensität
- höhere Intensität
- viele unterschiedliche und auch enge Wellenlängenbereiche möglich
- Beleuchtungsbreite (LED-Line) bzw. beleuchtet Fläche durch Anordnung mehrerer LEDs frei wählbar
- Vorgabe eines Intensitätsprofils möglich

Der Nachteil, zumindest von LEDs im UV-C-Bereich, sind die derzeit hohen Anschaffungskosten und der höhere Diffusierungsaufwand im Vergleich zu Röhrenleuchten.

Die beiden Lichtquellen 3, 4 sind durch eine lichtundurchlässige Trennwand 5 voneinander getrennt.

Im gegenständlichen Beispiel in Fig. 1 emittiert eine UV-C-Leuchte 3 UV-C-Strahlung mit einer maximalen Intensität bei einer Wellenlänge von 254 nm und ist so im Gehäuse 1 eingebaut, dass das UV-Licht durch einen hinter der UV-C-Leuchte 3 angeordneten Reflektor 7 in Richtung zu den Detektoren hin geleitet wird. Das UV-Licht durchläuft noch einen Filter 6, der einen Großteil des von der UV-C-Leuchte 3 emittierten Lichts im sichtbaren Bereich absorbiert und somit nahezu kein sichtbares Licht im Wellenlängenbereich des Fluoreszenzlichts zu den Detektoren leitet. Würde nämlich etwa blaues Licht von der UV-C-Leuchte 3 zum Detektor für Fluoreszenzlicht gelangen, würde dieses als Fluoreszenzstrahlung detektiert werden, weil diese ebenfalls im Bereich des blauen Lichts liegt.

Das von der zweiten Lichtquelle emittierte VIS-Licht durchläuft ebenfalls einen Filter 6, der emittiertes Licht im UV- und fluoreszierenden Bereich (< 500 nm) absorbiert.

Das Gehäuse 1 besteht zumindest im Bereich des UV-Lichtdurchtritts aus einer Quarzglasscheibe 9. Quarzglas weist einen hohe Durchlässigkeit für UV-C-Licht auf. Die Quarzglasscheibe 9 kann aber auch den Lichtdurchtritt des sichtbaren Lichts abdecken.

Die Quarzglasscheibe 9 dient auch als Rutsche für die zu untersuchenden Objekte 15 (Glasscherben, Störstoffe). Sie weist - im montierten Zustand der erfindungsgemäßen Vorrichtung - eine Neigung von etwa 25° gegenüber der Senkrechten auf. Auf ihr rutschen die Objekte 15 nach unten und werden dabei von den beiden Lichtquellen 3, 4 beleuchtet.

Der Abstand zwischen dem zu detektierenden Fluoreszenzlicht und dem zu detektierenden Transmissionslicht (aus Lichtquelle 4) sollte möglichst gering (im Idealfall deckungsgleich) sein, damit beide Detektoren, jener für Fluoreszenz- und jener für Transmissionslicht, ein möglichst übereinstimmendes Bild des bewegten Objekts 15 abbilden können. Der Abstand zwischen den Mittelachsen der Lichtstrahlen des sichtbaren Lichts bzw. des UV-Lichts, wenn diese aus dem Gehäuse 1 austreten, beträgt in diesem Beispiel etwa 50mm.

Sowohl das von den Objekten durchgelassene sichtbare Licht der VIS-Leuchte 4 als auch die gegebenenfalls durch das UV-Licht induzierte Fluoreszenzstrahlung im blauen sichtbaren Bereich gelangen durch ein Schutzglas 13 in das weitere Gehäuse 2, wo einerseits ein Detektor 11 zum Detektieren des Fluoreszenzlichts angebracht ist, und wo andererseits auch ein Detektor zum Detektieren des Transmissionslichts der zweiten Lichtquelle 4 angeordnet ist.

Das Schutzglas 13 besteht aus Normalglas und schützt den Innenraum von Gehäuse 2 vor Staub und UV-C Strahlung.

Der Detektor 11 zum Detektieren des Fluoreszenzlichts ist in einem Wellenlängenbereich von 400-1000 nm empfindlich, die Empfindlichkeit kann durch Filter weiter verändert werden, etwa hier auf den relevanten Wellenlängenbereich von 420-500 nm. (Würde man UV-Licht mit einer Wellenlänge von etwa 270 nm verwenden, so würde man das Filter so einstellen, dass nur Fluoreszenzlicht im Wellenlängenbereich von 400-450 nm detektiert werden kann). Der Detektor 11 wird in der Regel als Kamera ausgebildet sein. Er kann zum Beispiel als sogenannte TDI-Kamera 11 ausgebildet sein.

Um eine Störung der Detektion des Fluoreszenzlichts durch eine weitere Lichtquelle in diesem Wellenlängenbereich zu vermeiden, darf die zweite Lichtquelle 4 möglichst nur Licht außerhalb dieses Frequenzbereichs ausstrahlen. In der Praxis ist es oft so, dass selbst Lichtquellen im gelben oder roten Bereich, die also per Definition "Licht im sichtbaren Bereich oder IR-Licht außerhalb des Wellenlängenbereichs des Fluoreszenzlichts aussenden" noch einen Blauanteil im Licht haben, und dieser dann gegebenenfalls herausgefiltert werden muss, wie oben bei Filter 6 für die zweite Lichtquelle 4 erläutert.

Es hat sich gezeigt, dass im Besonderen zur Unterscheidung von Grün- und Braunglas zu KSP sichtbares Licht im Bereich Gelb/Orange (ca. 590 nm) die besten Ergebnisse liefert.

Zur Detektion des Transmissionlichts aus der zweiten Lichtquelle 4 ist es grundsätzlich ausreichend, wenn ein Detektor 10, also etwa eine Kamera, zumindest ein Bild von Glasstücken in Grauschattierungen liefern kann. Daraus kann dann einerseits die Lage und Form des Objekts 15 bestimmt werden, die notwendig ist, um das Objekt gegebenenfalls mittels nachgeordneter Austrageinrichtungen aus dem Materialstrom zu entfernen. Andererseits wird dadurch die Lichtdurchlässigkeit des Objekts (Glasstücks) 15 bestimmt und dieses als durchsichtig erkannt (es kann dann noch bleihaltig oder nicht bleihaltig sein) oder als wenig oder nicht durchsichtig (dann wäre es ein Störstoff). Entsprechend wird der Störstoff dann durch die Austrageinrichtungen aus dem Materialstrom entfernt. Es können mittels dieses Detektors auch die Ränder und Innenbereiche der Glasstücke durch Bilderkennung definiert werden und nur von diesen Teilbereichen der Scherbe die Intensität der Fluoreszenzstrahlung zur Auswertung des Bleiglasgehaltes herangezogen werden.

Der Detektor 10, in der Regel eine Kamera, ist daher zumindest in jenem Wellenlängenbereich empfindlich, in dem die zweite Lichtquelle 4 Licht aussendet. In diesem Beispiel wird eine sogenannte RGB-Kamera 10 verwendet. Bei dieser wird ein RGB-Signal verarbeitet, also die Farben Rot, Grün und Blau jeweils in einem eigenen Kanal übertragen beziehungsweise gespeichert.

Zur Detektion des Fluoreszenzlichts ist grundsätzlich ein hoch empfindlicher Detektor notwendig, in der Regel eine Kamera, in diesem Ausführungsbeispiel wurde eine sogenannte TDI-Kamera 11 verwendet. Diese enthält, wie die RGB-Kamera, einen CCD-Sensor, allerdings enthält dieser TDI (Time Delay Integration) Elemente, die besonders empfindlich sind und dennoch gute Aufnahmen von bewegten Objekten liefern.

Sowohl Fluoreszenzlicht als auch transmittiertes Licht treffen auf einen Strahlteiler 12, der blaues Licht, etwa im Wellenlängenbereich von 400-500 nm möglichst vollständig reflektiert sowie sichtbares Licht >500 nm (transmittiertes Licht) möglichst vollständig durchlässt. Der reflektierte Lichtstrahl wird in die TDI-Kamera 11 geleitet, der durchgelassene Lichtstrahl in die RGB-Kamera 10.

Die detektierten Daten werden einer Auswerte- und Steuereinheit zugeleitet, welche die einzelnen Glasstücke den verschiedenen Fraktionen
- Bleiglas (gegebenenfalls verschiedene Fraktionen mit unterschiedlichem Bleigehalt),
- Störstoffe (Keramik, Stein und Porzellan, "KSP"),
- Normalglas und
- gegebenenfalls Glaskeramik zuordnet und die Austrageinheiten steuert, welche die Glasstücke in die entsprechenden Container verbringt.

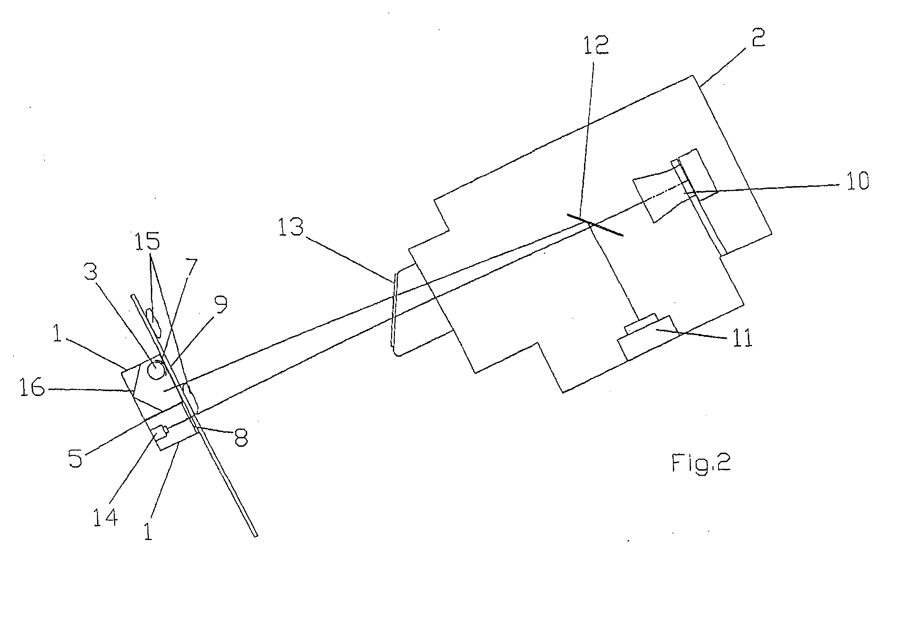

In Fig. 2 sind in einem Gehäuse 1 für Lichtquellen wieder sowohl eine UV-Lichtquelle 3 als auch eine zweite Lichtquelle 14 eingebaut, jedoch durch eine lichtundurchlässige Trennwand 5 voneinander getrennt.

Die UV-Lichtquelle 3 kann UV-Licht im Bereich von 100-280 nm aussenden, insbesondere zwischen 250 und 275 nm. Sie ist hier wieder in Form einer UV-C-Leuchte ausgeführt. Ebenso könnten statt einer UV-Röhre auch eine oder mehrere UV-C LEDs zu Anwendung kommen.

Die zweite Lichtquelle 14 kann Licht im sichtbaren Bereich (380-780 nm Wellenlänge) und/oder im Infrarotbereich (780 nm - 1 mm Wellenlänge) aussenden und etwa - wie in diesem Beispiel - als eine oder mehrere IR-LEDs (LED-Line) ausgeführt sein. Genauso könnte aber auch eine Lampe mit Wellenlängen im sichtbaren Bereich und/oder im Infrarotbereich oder eine oder mehrere Tageslicht- bzw. Farb-LEDs (LED-Line) verwendet werden.

Die UV-C-Leuchte 3 emittiert UV-C-Strahlung mit einer Wellenlänge von 254 nm und ist so im Gehäuse 1 eingebaut, dass das UV-Licht durch einen in Richtung der Detektoren angeordneten Reflektor 7 von den Detektoren weg geleitet und durch zwei rechtwinkelig zueinander angeordnete Spiegelfilter 16 um 180° umgelenkt und somit in Richtung zu den Detektoren hin geleitet wird. Die Spiegelfilter 16 sind Spiegel, die mit einer Beschichtung versehen sind, welche einen Großteil des von der UV-C-Leuchte 3 emittierten Lichts im sichtbaren Bereich absorbiert und somit nahezu kein sichtbares Licht im Wellenlängenbereich des Fluoreszenzlichts reflektiert und zu den Detektoren leitet. Würde nämlich etwa blaues Licht von der UV-C-Leuchte 3 zum Detektor für Fluoreszenzlicht gelangen, würde dieses als Fluoreszenzstrahlung detektiert werden, weil diese ebenfalls im Bereich des blauen Lichts liegt. Statt beschichteter Spiegelfilter 16 oder zusätzlich dazu könnten auch Filter für sichtbares Licht im Wellenlängenbereich des Fluoreszenzlichts in den Strahlengang des UV-Lichts gebracht werden.

Spiegelfilter 16 haben den Vorteil, dass sie auch in großen Breiten, etwa 1000mm, kostengünstig hergestellt werden können, welche der Breite von Förderbändern bzw. der Rutsche für Altglas entspricht. Klassische Filter haben einerseits den Nachteil, dass diese oft nur in kleinen Breiten (<200mm) hergestellt werden können und somit kein einstückiger Filter für die erfindungsgemäße Vorrichtung hergestellt werden kann, der die gesamte Breite des Förderbandes bzw. der Rutsche für Altglas abdecken kann.

Ein Spiegelfilter 16 hat in diesem Beispiel eine Höhe (gemessen in der Zeichenebene) von etwa 5-10 cm, insbesondere hier 7 cm. Die Breite (gemessen normal zu Zeichenebene) beträgt 50-150 cm, insbesondere hier 100 cm.

Als Grundmaterial für den Spiegelfilter 16 wird ein Metallblech mit einer Dicke von 1-2 mm verwendet. Die Beschichtung besteht aus Oxiden und hat eine Dicke von einigen Mikrometern.

Das IR-Licht der IR-LEDs 14 wird durch eine Streuscheibe 8 geleitet, um das Licht der punktförmigen IR-LEDs 14 homogener zu machen, und tritt parallel zum UV-Licht aus dem Gehäuse 1 aus. Statt einer Streuscheibe 8 können auch andere Einrichtungen verwendet werden, um das Licht gleichmäßiger zu verteilen, etwa ein auf seinen Innenseiten verspiegelter Reflexionskanal, wie er in der AT 10184 U1 gezeigt ist.

Das Gehäuse 1 besteht zumindest im Bereich des UV-Lichtdurchtritts aus einer Quarzglasscheibe 9 wie in Fig. 1. Die Quarzglasscheibe 9 kann aber auch hier den Lichtdurchtritt der zweiten Lichtquelle, der IR-LEDs 14, abdecken und als Rutsche für die zu untersuchenden Objekte dienen.

Der Abstand zwischen dem zu detektierenden Fluoreszenzlicht und dem zu detektierenden Transmissionslicht sollte auch hier möglichst gering (idealer Weise deckend) sein, damit beide Detektoren, jener für Fluoreszenz- und jener für Transmissionslicht, ein möglichst übereinstimmendes Bild des bewegten Objekts abbilden können. Der Abstand zwischen den Mittelachsen der Lichtstrahlen des IR-Lichts bzw. des UV-Lichts, wenn diese aus dem Gehäuse 1 austreten, beträgt in diesem Beispiel ebenfalls etwa 50mm.

Sowohl das von den Objekten 15 durchgelassene IR-Licht der IR-LEDs 14 als auch die gegebenenfalls durch das UV-Licht induzierte Fluoreszenzstrahlung im blauen sichtbaren Bereich gelangen durch ein Schutzglas 13 - wie unter Fig. 1 beschrieben in das weitere Gehäuse 2, wo einerseits ein Detektor 11 zum Detektieren des Fluoreszenzlichts angebracht ist, der wie unter Fig. 1 beschrieben auszubilden ist und der auch hier in Fig. 2 als sogenannte TDI-Kamera 11 ausgebildet ist, und wo andererseits auch ein Detektor 10 zum Detektieren des Transmissionslichts der zweiten Lichtquelle 14, der IR-LEDs 14, angeordnet ist. Der Detektor 10, in der Regel wieder eine Kamera, ist daher zumindest in jenem Wellenlängenbereich empfindlich, in dem die zweite Lichtquelle 14 Licht aussendet, also in diesem Fall in einem Bereich innerhalb des Wellenlängenbereichs von 780 nm -1 mm. Es kann auch hier wieder eine RGB-Kamera, gegebenenfalls mit vorgeschaltetem Filter, verwendet werden.

Um eine Störung der Detektion des Fluoreszenzlichts durch eine weitere Lichtquelle in diesem Wellenlängenbereich zu vermeiden, darf die zweite Lichtquelle möglichst nur Licht außerhalb dieses Frequenzbereichs ausstrahlen. Es wurde daher für dieses Anwendungsbeispiel ein bezüglich Wellenlänge möglichst weit vom Fluoreszenzlicht entferntes Licht, nämlich IR-Licht mit einer Wellenlänge von 860 nm, ausgewählt.

Es kann aber auch, besonders zur Unterscheidung von Grün- und Braunglas zu KSP, sichtbares Licht aus LEDs im Bereich Gelb/Orange (ca. 590 nm) verwendet werden, das hierfür die besten Ergebnisse liefert.

Zur Detektion des Transmissionlichts ist es, wie bei Fig. 1 bereits erläutert, grundsätzlich ausreichend, wenn der Detektor 10, also etwa eine Kamera, zumindest ein Bild von Objekten 15 in Grauschattierungen liefern kann. Daraus kann dann einerseits die Lage und Form des Objekts 15 bestimmt werden, die notwendig ist, um das Objekt 15 gegebenenfalls mittels nachgeordneter Austrageinrichtungen aus dem Materialstrom zu entfernen. Andererseits wird dadurch die Lichtdurchlässigkeit des Objekts (Glasstücks) 15 bestimmt und dieses als durchsichtig erkannt (es kann dann noch bleihaltig oder nicht bleihaltig sein) oder als wenig oder nicht durchsichtig (dann wäre es ein Störstoff). Entsprechend wird der Störstoff dann durch die Austrageinrichtungen aus dem Materialstrom entfernt. Es können mittels dieses Detektors auch die Ränder und Innenbereiche der Glasstücke durch Bilderkennung definiert werden und nur von diesen Teilbereichen der Scherbe die Intensität der Fluoreszenzstrahlung zur Auswertung des Bleiglasgehaltes herangezogen werden.

Sowohl Fluoreszenzlicht als auch transmittiertes IR-Licht treffen auf einen Strahlteiler 12, der blaues Licht, etwa im Wellenlängenbereich von 400-500 nm, möglichst vollständig reflektiert sowie IR-Licht, etwa im Wellenlängenbereich von 860 nm, möglichst vollständig durchlässt. Der reflektierte Lichtstrahl wird in die TDI-Kamera 11 geleitet, der durchgelassene Lichtstrahl in die RGB-Kamera 10. Die detektierten Daten werden einer Auswerte- und Steuereinheit zugeleitet, welche die einzelnen Glasstücke den verschiedenen Fraktionen
- Bleiglas (gegebenenfalls verschiedene Fraktionen mit unterschiedlichem Bleigehalt),
- Störstoffe (Keramik, Stein und Porzellan, "KSP"),
- Normalglas und
- gegebenenfalls Glaskeramik zuordnet und die Austrageinheiten steuert, welche die Glasstücke in die entsprechenden Container verbringt.

### BEZUGSZEICHENLISTE

- 1: Gehäuse für Lichtquellen
- 2: Gehäuse für Detektoren
- 3: UV-Lichtquelle (UV-C-Leuchte)
- 4: Zweite Lichtquelle (VIS-Leuchte)
- 5: Trennwand
- 6: Filter
- 7: Reflektor
- 8: Streuscheibe
- 9: Quarzglasscheibe
- 10: Detektor zur Detektion des Transmissionlichts (RGB-Kamera)
- 11: Detektor zur Detektion des Fluoreszenzlichts (TDI-Kamera)
- 12: Strahlteiler
- 13: Schutzglas
- 14: Zweite Lichtquelle
- 15: Objekt (Glasstück oder Störstoff)
- 16: Spiegelfilter

## Patentansprüche

1. Verfahren zum Detektieren von bleihältigen Glasstücken in einem einschichtigen Materialstrom von Objekten aus vorwiegend Altglas, wobei die Objekte mit im Wesentlichen monochromatischem UV-Licht (3) bestrahlt und das daraus resultierende Fluoreszenzlicht detektiert wird, **dadurch gekennzeichnet, dass**
- die Objekte zusätzlich mit sichtbarem oder IR-Licht (4, 14) außerhalb des Wellenlängenbereichs des Fluoreszenzlichts bestrahlt wird,
- das Transmissionslicht des sichtbaren oder IR-Lichts (4, 14) nach dem Durchgang durch das Objekt detektiert wird,
- und ein Objekt dann als bleihältig definiert wird, wenn sowohl Fluoreszenzlicht für zumindest einen vorbestimmten, der Fluoreszenz von bleihältigen Gläsern entsprechenden Wellenlängenbereich in einem vorbestimmten Intensitätsbereich vorliegt als auch Transmissionslicht in einem vorbestimmten Intensitätsbereich mit einer Intensität größer Null.

2. Verfahren nach Anspruch 1, **dadurch gekennzeichnet, dass** das UV-Licht (3) eine Wellenlänge im Bereich von 100 bis 300 nm, insbesondere zwischen 250 und 275 nm, aufweist und das das Fluoreszenzlicht im Wellenlängenbereich von 380-500 nm detektiert wird.

3. Verfahren nach Anspruch 2, **dadurch gekennzeichnet, dass** das UV-Licht (3) eine Wellenlänge von etwa 270 nm aufweist und das Fluoreszenzlicht im Wellenlängenbereich von 380-450 nm detektiert wird.

4. Verfahren nach Anspruch 2, **dadurch gekennzeichnet, dass** das UV-Licht (3) eine Wellenlänge von etwa 254 nm aufweist und das Fluoreszenzlicht im Wellenlängenbereich von 420-500 nm detektiert wird.

5. Verfahren nach einem der Ansprüche 1 bis 4, **dadurch gekennzeichnet, dass** das Fluoreszenzlicht im GegenlichtVerfahren gemessen wird.

6. Verfahren nach einem der Ansprüche 1 bis 5, **dadurch gekennzeichnet, dass** aufgrund der Intensität des Fluoreszenzlichts im vorherbestimmten Intensitätsbereich für bleihaltige Glasstücke eine weitere Unterteilung der bleihaltigen Glasstücke bezüglich Bleigehalt vorgenommen wird.

7. Verfahren nach einem der Ansprüche 1 bis 6, **dadurch gekennzeichnet, dass** für jedes untersuchte Objekt aufgrund der Bestrahlung mit sichtbarem oder IR-Licht (4, 14) ein Teilbereich, wie der Randbereich oder der Innenbereich, des Objekts bestimmt wird und nur die Intensität des Fluoreszenzlichts des Teilbereichs zur Definition des Bleigehalts herangezogen wird.

8. Verfahren nach einem der Ansprüche 1 bis 7, **dadurch gekennzeichnet, dass** ein Objekt als wenig oder nicht transparenter Störstoff definiert wird, wenn dessen Transmissionslicht in einem Intensitätsbereich liegt, der unter dem Intensitätsbereich für bleihaltige Glasstücke liegt.

9. Verfahren nach einem der Ansprüche 1 bis 8, **dadurch gekennzeichnet, dass** ein als bleihaltig und/oder als Störstoff definiertes Objekt aus dem Materialstrom entfernt wird.

10. Verfahren nach einem der Ansprüche 1 bis 9, **dadurch gekennzeichnet, dass** das Licht aus der UV-Lichtquelle (3) über zumindest einen Spiegelfilter (16) umgelenkt und gefiltert wird.

11. Vorrichtung zur Durchführung eines Verfahrens nach einem der Ansprüche 1 bis 10, **dadurch gekennzeichnet, dass** diese zumindest umfasst:
- eine im Wesentlichen monochromatische UV-Lichtquelle (3), mit welcher ein einschichtiger Materialstrom von Objekten aus vorwiegend Altglas beleuchtet werden kann,
- ein erster Detektor (11) zum Detektieren des durch die UV-Lichtquelle (3) im Objekt erzeugten Fluoreszenzlichts,
- eine zweite Lichtquelle (4, 14), die Licht im sichtbaren Bereich oder IR-Licht außerhalb des Wellenlängenbereichs des Fluoreszenzlichts aussenden kann,
- einen zweiten Detektor (10) zum Detektieren des Transmissionslichts des sichtbaren oder IR-Lichts nach dem Durchgang durch das Objekt,
- eine Einrichtung (9) zum Herstellen eines einschichtigen Materialstroms aus Altglas, mit welcher der Materialstrom an der UV-Lichtquelle (3) und an der zweiten Lichtquelle (4, 14) vorbeigeführt werden kann,
- sowie eine Einrichtung zum Aussortieren von bleihältigen Glasstücken, die dann ein Objekt aussortiert, wenn sowohl Fluoreszenzlicht für zumindest einen vorbestimmten, der Fluoreszenz von bleihältigen Gläsern entsprechenden Wellenlängenbereich in einem vorbestimmten Intensitätsbereich vorliegt als auch Transmissionslicht in einem vorbestimmten Intensitätsbereich mit einer Intensität größer Null.

12. Vorrichtung nach Anspruch 11, **dadurch gekennzeichnet, dass** die UV-Lichtquelle (3) UV-Licht mit einer Wellenlänge im Bereich von 100 bis 300 nm, insbesondere zwischen 250 und 275 nm, aussenden kann und der erste Detektor (11) Fluoreszenzlicht nur im Wellenlängenbereich von 380-500 nm detektieren kann.

13. Vorrichtung nach Anspruch 12, **dadurch gekennzeichnet, dass** das UV-Licht eine Wellenlänge von etwa 270 nm aufweist und das Fluoreszenzlicht im Wellenlängenbereich von 380-450 nm detektiert wird.

14. Vorrichtung nach Anspruch 12, **dadurch gekennzeichnet, dass** das UV-Licht eine Wellenlänge von etwa 254 nm aufweist und das Fluoreszenzlicht im Wellenlängenbereich von 420-500 nm detektiert wird.

15. Vorrichtung nach einem der Ansprüche 11 bis 14, **dadurch gekennzeichnet, dass** sich UV-Lichtquelle (3) und der erste Detektor (11) auf verschiedenen Seiten des Materialstroms befinden.

16. Vorrichtung nach einem der Ansprüche 11 bis 15, **dadurch gekennzeichnet, dass** sich UV-Lichtquelle (3) und zweite Lichtquelle (4, 14) in einem gemeinsamen Gehäuse befinden.

17. Vorrichtung nach einem der Ansprüche 11 bis 16, **dadurch gekennzeichnet, dass** sich erster (11) und zweiter (10) Detektor in einem gemeinsamen Gehäuse befinden.

18. Vorrichtung nach einem der Ansprüche 11 bis 17, **dadurch gekennzeichnet, dass** die UV-Lichtquelle (3) so in ein Gehäuse mit zumindest einem Spiegelfilter (16) eingebaut ist, dass das Licht aus der UV-Lichtquelle (3) über zumindest einen Spiegelfilter (16) umgelenkt und gefiltert wird, insbesondere durch zwei normal zueinander angeordnete Spiegelfilter (16) um 180° umgelenkt wird.

## Claims

1. A method for detecting leaded pieces of glass in a single-layer material flow of objects consisting predominantly of waste glass, with the objects being irradiated with substantially monochromatic UV light (3) and the fluorescent light resulting therefrom being detected, **characterized in that**
- the objects are additionally irradiated with visible or infrared light (4, 14) outside of the wavelength range of the fluorescent light;
- the transmission light of the visible or infrared light (4, 14) is detected after the passage through the object;
- and an object is defined as containing lead if both the fluorescent light for at least one predetermined wavelength range corresponding to the fluorescence of leaded glasses is present in a predetermined intensity range and also transmission light in a predetermined intensity range with an intensity of larger zero.

2. A method according to claim 1, **characterized in that** the UV light (3) has a wavelength in the range of 100 to 300 nm, especially between 250 and 275 nm, and the fluorescent light is detected in the wavelength range of 380 to 500 nm.

3. A method according to claim 2, **characterized in that** the UV light (3) has a wavelength of approx. 270 nm and the fluorescent light is detected in the wavelength range of 380 to 450 nm.

4. A method according to claim 2, **characterized in that** the UV light (3) has a wavelength of approx. 254 nm and the fluorescent light is detected in the wavelength range of 420 to 500 nm.

5. A method according to one of the claims 1 to 4, **characterized in that** the fluorescent light is measured by the backlighting method.

6. A method according to one of the claims 1 to 5, **characterized in that** a further subdivision of the leaded pieces of glass is made with respect to the lead content as a result of the intensity of the fluorescent light in the predetermined intensity range.

7. A method according to one of the claims 1 to 6, **characterized in that** a partial area such as the boundary area or the inner area of the object is determined for each examined object on the basis of radiation with visible or infrared light (4, 14) and only the intensity of the fluorescent light of the partial area will be used for defining the lead content.

8. A method according to one of the claims 1 to 7, **characterized in that** an object will be defined as a low-transparent or non-transparent impurity when its transmission light lies in an intensity range which lies beneath the intensity range for leaded pieces of glass.

9. A method according to one of the claims 1 to 8, **characterized in that** an object defined as leaded and/or as an impurity will be removed from the material flow.

10. A method according to one of the claims 1 to 9, **characterized in that** the light from the UV light source (3) is deflected and filtered via at least one mirror filter (16).

11. An apparatus for performing a method according to one of the claims 1 to 10, **characterized in that** it comprises at least the following:
- a substantially monochromatic UV light source (3), with which a single-layer material flow of objects of predominantly waste glass can be illuminated;
- a first detector (11) for detecting the fluorescent light generated by the UV light source (3) in the object;
- a second light source (4, 14) which is capable of emitting light in the visible range or infrared light outside of the wavelength range of the fluorescent light;
- a second detector (10) for detecting the transmission light of the visible or infrared light after passing through the object;
- a device (9) for producing a single-layer material flow of waste glass, with which the material flow can be guided past the UV light source (3) and the second light source (4, 14);
- and a device for sorting out leaded glass pieces, which will sort out an object when both fluorescent light is present in a predetermined intensity range for at least one predetermined wavelength range corresponding to the fluorescence of leaded glasses and also transmission light in a predetermined intensity range with an intensity of larger zero.

12. An apparatus according to claim 11, **characterized in that** the UV light source (3) is capable of emitting UV light with a wavelength in the range of 100 to 300 nm, especially between 250 and 275 nm, and the first detector (11) is capable of detecting fluorescent light only in the wavelength range of 380 to 500 nm.

13. An apparatus according to claim 12, **characterized in that** the UV light has a wavelength of approx. 270 nm and the fluorescent light is detected in the wavelength range of 380 to 450 nm.

14. An apparatus according to claim 12, **characterized in that** the UV light has a wavelength of approx. 254 nm and the fluorescent light is detected in the wavelength range of 420 to 500 nm.

15. An apparatus according to one of the claims 11 to 14, **characterized in that** the UV light source (3) and the first detector (11) are disposed on different sides of the material flow.

16. An apparatus according to one of the claims 11 to 15, **characterized in that** the UV light source (3) and the second light source (4, 14) are disposed in a common housing.

17. An apparatus according to one of the claims 11 to 16, **characterized in that** the first (11) and second (10) detector are disposed in a common housing.

18. An apparatus according to one of the claims 11 to 17, **characterized in that** the UV light source (3) is installed in a housing with at least one mirror filter (16) in such a way that the light from the UV light source (3) is deflected and filtered via at least one mirror filter (16), especially deflected by 180° by means of two mirror filters (16) disposed normally with respect to each other.

## Revendications

1. Procédé pour détecter des morceaux de verre contenant du plomb dans un flux de matière en une couche composé d'objets en verre principalement usagé, dans lequel les objets sont exposés à une lumière ultraviolette sensiblement monochromatique (3) et la lumière de fluorescence en résultant est détectée, **caractérisé en ce que**
- les objets sont exposés en outre à de la lumière visible ou infrarouge (4, 14) en dehors de la longueur d'ondes de la lumière de fluorescence,
- la lumière visible ou IR (4, 14) transmise est détectée après le passage à travers l'objet,
- et un objet est défini comme contenant du plomb en présence à la fois de lumière de fluorescence dans au moins une plage de longueur d'ondes correspondant à la fluorescence des verres contenant du plomb et de lumière transmise dans une plage d'intensité prédéterminée d'une intensité supérieure à zéro.

2. Procédé selon la revendication 1, **caractérisé en ce que** la lumière UV (3) a une longueur d'ondes comprise entre 100 et 300 nm, en particulier entre 250 et 275 nm, et la lumière de fluorescence est détectée dans la plage de longueur d'ondes de 380 à 500 nm.

3. Procédé selon la revendication 2, **caractérisé en ce que** la lumière UV (3) a une longueur d'ondes d'environ 270 nm et la lumière de fluorescence est détectée dans la plage de longueur d'ondes de 380 à 450 nm.

4. Procédé selon la revendication 2, **caractérisé en ce que** la lumière UV (3) a une longueur d'ondes d'environ 254 nm et la lumière de fluorescence est détectée dans la plage de longueur d'ondes de 420 à 500 nm.

5. Procédé selon l'une des revendications 1 à 4, **caractérisé en ce que** la lumière de fluorescence est mesurée selon la méthode à contre-jour.

6. Procédé selon l'une des revendications 1 à 5, **caractérisé en ce que** les morceaux de verre contenant du plomb sont encore différenciés selon leur teneur en plomb sur la base de l'intensité de la lumière de fluorescence dans la plage d'intensité prédéterminée pour les morceaux de verre contenant du plomb.

7. Procédé selon l'une des revendications 1 à 6, **caractérisé en ce que** pour chaque objet examiné, une partie de l'objet, par exemple le bord ou l'intérieur, est déterminée sur la base de l'exposition à la lumière visible ou IR (4, 14) et seule l'intensité de la lumière de fluorescence de cette partie est utilisée pour définir la teneur en plomb.

8. Procédé selon l'une des revendications 1 à 7, **caractérisé en ce qu'**un objet est défini comme une matière parasite peu ou non transparente si sa lumière transmise se situe dans une plage d'intensité inférieure à la plage d'intensité pour les morceaux de verre contenant du plomb.

9. Procédé selon l'une des revendications 1 à 8, **caractérisé en ce qu'**un objet défini comme contenant du plomb et/ou comme une matière parasite est retiré du flux de matière.

10. Procédé selon l'une des revendications 1 à 9, **caractérisé en ce que** la lumière provenant de la source de lumière UV (3) est déviée et filtrée par au moins un filtre à miroir (16).

11. Dispositif pour la mise en oeuvre d'un procédé selon l'une des revendications 1 à 10, **caractérisé en ce qu'**il comprend au moins :
- une source de lumière UV sensiblement monochromatique (3) avec laquelle un flux de matière en une couche composé d'objets en verre principalement usagé peut être éclairé,
- un premier détecteur (11) pour détecter la lumière de fluorescence générée par la source de lumière UV (3) dans l'objet,
- une deuxième source lumineuse (4, 14) qui peut émettre de la lumière dans la plage visible ou IR en dehors de la plage de longueur d'ondes de la lumière de fluorescence,
- un deuxième détecteur (10) pour détecter la lumière visible ou IR transmise après son passage à travers l'objet,
- un dispositif (9) pour créer le flux de matière en une couche composé de verre usagé, avec lequel le flux de matière peut être passé devant la source de lumière UV (3) et la deuxième source lumineuse (4, 14),
- et un dispositif pour trier des morceaux de verre contenant du plomb, qui extrait un objet quand aussi bien une lumière de fluorescence pour au moins une plage de longueur d'ondes prédéterminée correspondant à la fluorescence des verres contenant du plomb dans une plage d'intensité prédéterminée qu'une lumière transmise dans une plage d'intensité prédéterminée d'une intensité supérieure à zéro sont présentes.

12. Dispositif selon la revendication 11, **caractérisé en ce que** la source de lumière UV (3) peut émettre la lumière UV à une longueur d'ondes comprise entre 100 et 300 nm, en particulier entre 250 et 275 nm, et le premier détecteur (11) ne peut détecter la lumière de fluorescence que dans la plage de longueur d'ondes de 380 à 500 nm.

13. Dispositif selon la revendication 12, **caractérisé en ce que** la lumière UV a une longueur d'ondes d'environ 270 nm et la lumière de fluorescence est détectée dans la plage de longueur d'ondes de 380 à 450 nm.

14. Dispositif selon la revendication 12, **caractérisé en ce que** la lumière UV a une longueur d'ondes d'environ 254 nm et la lumière de fluorescence est détectée dans la plage de longueur d'ondes de 420 à 500 nm.

15. Dispositif selon l'une des revendications 11 à 14, **caractérisé en ce que** la source de lumière UV (3) et le premier détecteur (11) se trouvent sur des côtés différents du flux de matière.

16. Dispositif selon l'une des revendications 11 à 15, **caractérisé en ce que** la source de lumière UV (3) et la deuxième source lumineuse (4, 14) se trouvent dans un boîtier commun.

17. Dispositif selon l'une des revendications 11 à 16, **caractérisé en ce que** le premier détecteur (11) et le deuxième (10) se trouvent dans un boîtier commun.

18. Dispositif selon l'une des revendications 11 à 17, **caractérisé en ce que** la source de lumière UV (3) est installée dans un boîtier avec au moins un filtre à miroir (16) de telle façon que la lumière sortant de la source de lumière UV (3) soit déviée et filtrée par au moins un filtre à miroir (16), en particulier déviée de 180° par deux filtres à miroir (16) disposés perpendiculairement l'un à l'autre.
